(19) Europäisches Patentamt
European Patent Office
Office européen des brevets

(11) **EP 4 373 238 A1**

(12) **EUROPEAN PATENT APPLICATION**
published in accordance with Art. 153(4) EPC

(43) Date of publication:
**22.05.2024 Bulletin 2024/21**

(21) Application number: **22860293.4**

(22) Date of filing: **15.08.2022**

(51) International Patent Classification (IPC):
**H10K 59/00** (2023.01)

(52) Cooperative Patent Classification (CPC):
**G01J 1/16; G09F 9/33; H01L 27/15; H10K 59/10; H10K 59/38; H10K 59/60**

(86) International application number:
**PCT/CN2022/112471**

(87) International publication number:
**WO 2023/024947 (02.03.2023 Gazette 2023/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.08.2021 CN 202110992375**

(71) Applicant: **Huawei Technologies Co., Ltd.
Shenzhen, Guangdong 518129 (CN)**

(72) Inventors:
• **HAN, Gangfeng
Shenzhen, Guangdong 518129 (CN)**
• **LI, Wei
Shenzhen, Guangdong 518129 (CN)**
• **MENG, Chao
Shenzhen, Guangdong 518129 (CN)**
• **CHOO, Kyoseop
Shenzhen, Guangdong 518129 (CN)**

(74) Representative: **Gill Jennings & Every LLP
The Broadgate Tower
20 Primrose Street
London EC2A 2ES (GB)**

(54) **DISPLAY MODULE AND ELECTRONIC DEVICE**

(57) This application provides a display module and an electronic device. The display module includes an ultraviolet filter structure, an ultraviolet light conversion layer, a polarizer, and a light sensor. Ultraviolet light emitted from the outside passes through the ultraviolet filter structure. The ultraviolet light conversion layer can convert the ultraviolet light from the ultraviolet filter structure into visible light or infrared light. The ultraviolet light conversion layer emits the visible light or the infrared light into the light sensor through the polarizer. This application provides a display module and an electronic device that have an ultraviolet filter structure. This helps reduce impact of external visible light on ultraviolet light detection and improve ultraviolet light detection precision.

FIG. 3

## Description

This application claims priority to Chinese Patent Application No. 202110992375.0, filed with the China National Intellectual Property Administration on August 27, 2021 and entitled "DISPLAY MODULE AND ELECTRONIC DEVICE", which is incorporated herein by reference in its entirety.

## TECHNICAL FIELD

This application relates to the fields of display and electronic devices, and more specifically, to a display module and an electronic device.

## BACKGROUND

A user may obtain information related to an ultraviolet light intensity by using an electronic device, to take an appropriate protection measure for ultraviolet light. For example, the electronic device may detect the ultraviolet light intensity by using a light sensor. To reduce space required for disposing the light sensor, the light sensor may be disposed in a stacked manner with a display module of the electronic device, and is located outside a display area of the display module. In this way, the light sensor does not interfere with the display area, and impact of the light sensor on a screen-to-body ratio of the electronic device is reduced. However, a series of changes occur after external light passes through a plurality of optical structure layers of the display module, and consequently, detection precision of the light sensor is affected.

## SUMMARY

This application provides a display module and an electronic device, to improve ultraviolet light detection precision.

According to a first aspect, a display module is provided, including an ultraviolet filter structure, an ultraviolet light conversion layer, a polarizer, and a display panel that are disposed in a stacked manner, where the ultraviolet light conversion layer is located between the ultraviolet filter structure and the polarizer, and the display panel is located on a side that is of the polarizer and that is away from the ultraviolet filter structure.

The display panel includes a light emitting unit, a first light sensor, a front panel, and a backplane, where the light emitting unit is located between the front panel and the backplane, the first light sensor is located between the front panel and the backplane, and an orthographic projection of the light emitting unit on the backplane does not cross an orthographic projection of the first light sensor on the backplane.

Light emitted by the light emitting unit is configured to be emitted from the display module through the polarizer.

The ultraviolet filter structure is configured to: receive light emitted into the display module, and emit ultraviolet light filtered by the ultraviolet filter structure.

The ultraviolet light conversion layer is configured to convert the ultraviolet light from the ultraviolet filter structure into visible light or infrared light, and the light emitted from the ultraviolet light conversion layer is configured to be emitted into the first light sensor through the polarizer.

The first light sensor is configured to detect a light intensity of the light from the polarizer.

Disposing a light sensor in the display module helps to provide space for another component of the electronic device to occupy, and further helps reduce a cutting process for the polarizer, the display panel, and the like, reduce process complexity, and improve space utilization. The light sensor is disposed in the display module, so that light emitted into the light sensor may pass through the polarizer of the display module. The polarizer can absorb ultraviolet light, and therefore the polarizer may affect ultraviolet light detection by the light sensor. The ultraviolet filter structure and the ultraviolet light conversion layer are disposed, so that light emitted from the ultraviolet light conversion layer is visible light or infrared light, thereby helping reduce impact of the polarizer on ultraviolet light detection by the light sensor.

In this application, the ultraviolet filter structure is disposed. The ultraviolet filter structure may have a stable ultraviolet filter function, so that a proportion of ultraviolet light emitted into the ultraviolet light conversion layer may be high and stable. In this way, the electronic device or the display module can accurately detect a light intensity of external ultraviolet light. It is assumed that two light sensors are disposed, one light sensor detects visible light and infrared light from the outside, and the other light sensor detects visible light, infrared light, and ultraviolet light from the outside. The two light sensors may not have a same detection error for the visible light. Therefore, mutual offset is not necessarily implemented by disposing the two light sensors. Most of external natural light is visible light, and a small part is ultraviolet light. If the light sensor can detect much visible light, an error range of visible light detected by the light sensor may be equivalent to a light intensity of ultraviolet light detected by the light sensor. Therefore, an error of ultraviolet light detection may be large.

With reference to the first aspect, in some implementations of the first aspect, the ultraviolet filter structure includes a first part and a second part, the first part is configured to emit light filtered by the first part to the ultraviolet light conversion layer, the second part is configured to emit light filtered by the second part to the polarizer, an orthographic projection of the ultraviolet light conversion layer on the ultraviolet filter structure is located outside the second part, and the first light sensor is disposed opposite to the first part; and the display module further includes:

a second light sensor, where the second light sensor is located on the side that is of the polarizer and that is away from the ultraviolet filter structure, and is disposed opposite to the second part, and the second light sensor is configured to detect the light intensity of the light from the polarizer.

The first light sensor may detect visible light that passes through the ultraviolet filter layer. Consequently, an error may exist in the light intensity of the ultraviolet light that is detected by the first light sensor. That is, in addition to detecting external ultraviolet, the first light sensor further detects a small amount of external visible light. As a result, the light intensity detected by the first light sensor is relatively high. Because the second light sensor may detect visible light that passes through the ultraviolet filter layer, an ultraviolet light intensity is determined with reference to a detection result of the first light sensor and a detection result of the second light sensor, and this helps reduce a detection error of the ultraviolet light intensity. In addition, by combining the detection result of the first light sensor and the detection result of the second light sensor, impact of a dark current on ultraviolet light detection accuracy is further reduced. For the impact of the visible light and the dark current on ultraviolet light detection, two light sensors are disposed, which helps reduce space required for disposing the light sensor in the electronic device.

With reference to the first aspect, in some implementations of the first aspect, a current flowing in the first light sensor is $I_1$, a current flowing in the second light sensor is $I_2$, and a light intensity $L_{0,UV}$ of external ultraviolet light satisfies:

$$L_{0,UV}=(I_1-k_1 \times I_2)/k2,$$

where

$k_1$ is 1 or $T_{VL}$, and $T_{VL}$ is a visible light transmittance or an infrared light transmittance of the ultraviolet light conversion layer; and
$k_2$ is obtained based on one or more of the following: an ultraviolet light transmittance $T_{UV}$ of the ultraviolet filter structure, conversion efficiency $\eta_{UV}$ of the ultraviolet light conversion layer, a visible light transmittance or an infrared light transmittance $T_{POL}$ of the polarizer, and optical-to-electrical conversion efficiency $E_1$ of the first light sensor.

The light intensity of the external ultraviolet light is deduced based on optical performance of each component in the display module, and this helps improve ultraviolet light detection precision.

With reference to the first aspect, in some implementations of the first aspect, the display module further includes a light shielding layer, and the light shielding layer surrounds a periphery of the ultraviolet filter structure.

The light shielding layer may block light from the outside, so that the light from the outside can be emitted into the light sensor through an area circled by the light shielding layer. In addition, the light shielding layer may further absorb light emitted by the light emitting unit, and this helps reduce impact of the light emitted by the light emitting unit on ultraviolet light detection, thereby improving ultraviolet light detection accuracy.

With reference to the first aspect, in some implementations of the first aspect, the ultraviolet filter structure includes ultraviolet filter ink and a nano-silver film that are disposed in a stacked manner.

The ultraviolet filter ink and nano-silver film that are disposed in a stacked manner absorb or filter out most visible light, and this helps reduce a proportion of visible light that passes through the ultraviolet filter layer.

With reference to the first aspect, in some implementations of the first aspect, the nano-silver film is located on a side that is of the ultraviolet filter ink and that is close to the polarizer.

A small part of visible light that passes through the ultraviolet filter ink can be further absorbed by the nano-silver film. Visible light reflected by the nano-silver film can be emitted into the ultraviolet filter ink and absorbed by the ultraviolet filter ink.

With reference to the first aspect, in some implementations of the first aspect, an orthographic projection of the ultraviolet filter structure on the polarizer is located in an orthographic projection of the ultraviolet light conversion layer on the polarizer.

In an embodiment, an edge of the ultraviolet light conversion layer extends relative to the ultraviolet filter structure.

In this way, light emitted in a divergence form at an edge of the ultraviolet filter layer can be emitted into the ultraviolet light conversion layer as much as possible.

With reference to the first aspect, in some implementations of the first aspect, the ultraviolet light conversion layer is configured to convert ultraviolet light of a first wavelength from the ultraviolet filter structure into visible light or infrared light of a second wavelength, and the first light sensor is specifically configured to detect the visible light or the infrared light of the second wavelength.

The first light sensor detects light of a specific wavelength that is obtained through conversion by the ultraviolet light conversion layer, and this helps reduce light of another wavelength that is detected by the light sensor, and helps improve ultraviolet light detection precision.

With reference to the first aspect, in some implementations of the first aspect, the display module further includes a third light sensor, the ultraviolet light conversion layer is configured to convert ultraviolet light of a third wavelength from the ultraviolet filter structure into visible light or infrared light of a fourth wavelength, the light emitted from the ultraviolet light conversion layer is configured to be emitted into the third light sensor through the polarizer, and the third light sensor is configured to detect the visible light or the infrared light of the fourth wavelength.

Because different types of ultraviolet light have different impact on a human body, separately detecting a plurality of types of ultraviolet light helps provide an appropriate sun protection policy for a user based on light intensities of a plurality of types of external ultraviolet light.

With reference to the first aspect, in some implementations of the first aspect, the display module further includes a cover plate, and the ultraviolet filter structure is disposed on the cover plate.

A size of the cover plate may be large, and a large ultraviolet light conversion structure and a large ultraviolet filter structure may be disposed on the display module, thereby helping improve ultraviolet light detection performance of the display module.

With reference to the first aspect, in some implementations of the first aspect, the ultraviolet light conversion layer is attached to the ultraviolet filter structure.

The ultraviolet light conversion layer and the ultraviolet filter structure can be attached to each other to reduce a loss of ultraviolet light that passes through the ultraviolet light conversion layer and the ultraviolet filter structure.

With reference to the first aspect, in some implementations of the first aspect, the display module further includes a display panel, the display panel includes a front panel and a backplane, the first light sensor is packaged between the front panel and the backplane, and the first light sensor is electrically connected to a drive circuit on the backplane.

The light sensor may be packaged by using the display panel, and this helps reduce cutting techniques for the polarizer, the display panel, and the like due to disposing of the light sensor, reduce process complexity, and improve space utilization.

According to a second aspect, an electronic device is provided, including the display module according to any one of the implementations of the first aspect.

**BRIEF DESCRIPTION OF DRAWINGS**

FIG. 1 is a schematic diagram of a structure of an electronic device according to an embodiment of this application;

FIG. 2 is a schematic diagram of a structure of another electronic device according to an embodiment of this application;

FIG. 3 is a diagram of a local structure of a display module according to an embodiment of this application;

FIG. 4 is a diagram of an electrical connection of an electronic device according to an embodiment of this application;

FIG. 5 is a schematic diagram of a structure of an ultraviolet detection area according to an embodiment of this application;

FIG. 6 is a schematic diagram of another structure of an ultraviolet detection area according to an embodiment of this application;

FIG. 7 is a schematic diagram of still another structure of an ultraviolet detection area according to an embodiment of this application;

FIG. 8 is a schematic diagram of yet another structure of an ultraviolet detection area according to an embodiment of this application;

FIG. 9 is a diagram of a relationship between a dark current and temperature of a light sensor;

FIG. 10 is a schematic diagram of a light filter parameter of ultraviolet filter ink according to an embodiment of this application;

FIG. 11 is a schematic diagram of a light filter parameter of a nano-silver film according to an embodiment of this application;

FIG. 12 is a schematic diagram of a structure of a light filter principle of superimposing ultraviolet filter ink and a nano-silver film according to an embodiment of this application;

FIG. 13 is a schematic diagram of a light filter parameter of superimposing ultraviolet filter ink and a nano-silver film according to an embodiment of this application;

FIG. 14 is a diagram of a software architecture of an electronic device according to an embodiment of this application;

FIG. 15 is a diagram of a relationship between an ultraviolet light intensity and illuminance that is obtained by a light sensor according to an embodiment of this application;

FIG. 16 is a schematic diagram of a structure of a user interface according to an embodiment of this application; and

FIG. 17 is a schematic diagram of a structure of another user interface according to an embodiment of this application.

**DESCRIPTION OF EMBODIMENTS**

The following describes technical solutions of this application with reference to accompanying drawings.

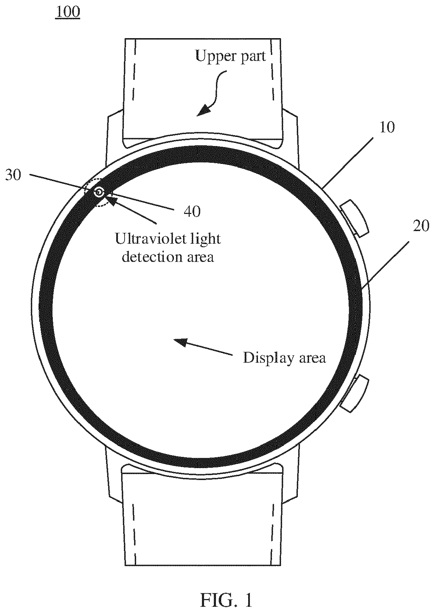

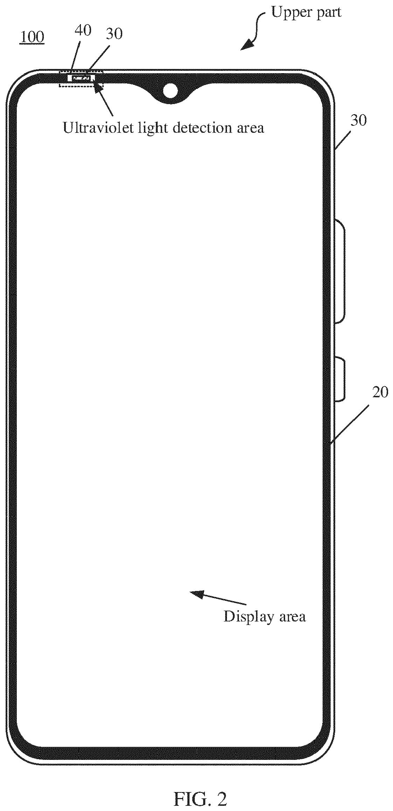

FIG. 1 and FIG. 2 each are a schematic diagram of a structure of an electronic device 100 according to an embodiment of this application. The electronic device 100 may be, for example, a terminal consumer product or a 3C electronic product (a computer (computer), communication (communication), or consumer (consumer) electronic product), for example, a device like a mobile phone, a mobile power supply, a portable computer, a tablet computer, an e-reader, a notebook computer, a digital camera, a wearable device, or a headset. An embodiment shown in FIG. 1 is described by using an example in which the electronic device 100 is a watch. An embodiment shown in FIG. 2 is described by using an example in which the electronic device 100 is a mobile phone.

The electronic device 100 may include a housing, a display module 20, and one or more light sensors 30. Specifically, the housing may include a frame 10 and a rear cover. The frame 10 may be located between the display module 20 and the rear cover. The frame 10 may surround a periphery of the display module 20 and surround a periphery of the rear cover. A plurality of light emitting units are disposed in the display module 20. Light emitted by the light emitting unit may be emitted from a display area of the display module 20, so that a user can observe, in the display area of the display module 20, an image displayed by the electronic device 100. The display area of the display module 20 may be an area that is of the display module 20 and that is used to display an image.

The light sensor 30 may be packaged inside the display module 20, or may be disposed outside the display module 20 in a stacked manner with the display module 20. In an embodiment of this application, the light sensor 30 may be located outside the display area of the display module 20, to prevent the light sensor 30 from blocking the display area. The light sensor 30 may correspond to an ultraviolet light detection area of the display module 20. The ultraviolet light detection area may be located between the display area and the frame of the display module 20. The ultraviolet light detection area may be an area enclosed by a light inlet 40 of the display module 20. Light from the outside may be emitted into the light sensor 30 through the light inlet 40 of the display module 20, so that the light sensor 30 can detect a light intensity of the light from the outside. The light intensity detected by the light sensor 30 may reflect a light intensity of external ultraviolet light. Light emitted by the light emitting unit may basically not be emitted from the light inlet 40 of the display module 20. The light inlets 40 shown in FIG. 1 and FIG. 2 are merely examples. A size, a quantity, and the like of the light inlet 40 may not be limited in this embodiment of this application. In some other embodiments of this application, the light sensor 30 may alternatively be located between the display module 20 and the frame 10.

The light sensor 30 may be referred to as, for example, a photo-diode (photo-diode, PD), a photo detector (photo detector, PD), or the like. The light sensor 30 includes but is not limited to any one of the following: a low temperature poly-silicon (low temperature poly-silicon, LTPS) PD, an oxide (oxide) PD, and an organic (organic) PD.

The display area of the display module 20 and the light sensor 30 may not interfere with each other. For example, the light sensor 30 does not block light emitted by the display module 20, and therefore does not block the display area of the display module 20 to display an image. Light from the display area of the display module 20 may not be emitted into the light sensor 30, or a very small amount of light from the display area of the display module 20 may be emitted into the light sensor 30, so that the light can be ignored.

For example, the light sensor 30 may be disposed on an upper part of a front surface of the electronic device 100 (the front surface of the electronic device 100 may be a surface that is often observed by the user, for example, a surface that is of the electronic device 100 and on which the display area is disposed). In the embodiment shown in FIG. 1, the light sensor 30 may be located on an upper part of a watch face, for example, an upper left part (as shown in FIG. 1) or an upper right part. In the embodiment shown in FIG. 2, the light sensor 30 may be located on a top of a display surface of the mobile phone, for example, located around components such as a front-facing camera and an earpiece.

According to a common use habit of the user, the user seldom operates the electronic device 100 from the upper part of the electronic device 100 because when the user operates the electronic device 100 from the upper part of the electronic device 100, a hand of the user may block a large part of the display area of the display module 20, thereby affecting observation of the display area by the user. Compared with another surface of the electronic device 100, when the user uses the electronic device 100 outdoors, the front surface of the electronic device 100 is relatively easier to face an ultraviolet light source (for example, the sun). Therefore, disposing the light sensor 30 on the upper part of the front surface of the electronic device 100 helps improve convenience of detecting ultraviolet light by the electronic device 100. For example, this helps prevent the user from changing a placement position of the electronic device 100 to detect ultraviolet light, and helps prevent the user from interrupting an operation on the electronic device 100 to detect ultraviolet light.

In another embodiment, the light sensor 30 may be located in another area of the electronic device 100, for example, a back of the electronic device 100, a lower part of the front surface of the electronic device 100, or a side edge of the electronic device 100. A position of the light sensor 30 in the electronic device 100 may not be limited in this embodiment of this application.

When the electronic device 100 includes a plurality of light sensors 30, in some embodiments, the plurality of light sensors 30 may be arranged, for example, in parallel to the frame 10. This manner of arranging the plurality of light sensors 30 helps improve a screen-to-body ratio of the electronic device 100. The watch shown in FIG. 1 is used as an example. When the frame 10 may be considered as a round ring, the plurality of light sensors 30 may be arranged on a same round ring that is of a different size from the frame 10 and that is coaxial with the frame 10. The mobile phone shown in FIG. 2 is used as an example. When the frame 10 may be considered as a square ring, the plurality of light sensors 30 may be arranged along a same side edge of the frame 10 and disposed close to the side edge.

In some other embodiments, the plurality of light sensors 30 may alternatively be arranged perpendicular to the frame 10. That is, the plurality of light sensors 30 may be arranged from outside to inside relative to the frame 10. The plurality of light sensors 30 may alternatively be arranged in the electronic device 100 in another mode. An arrangement mode of the plurality of light sensors 30 in the electronic device 100 may not be limited in this embodiment of this application.

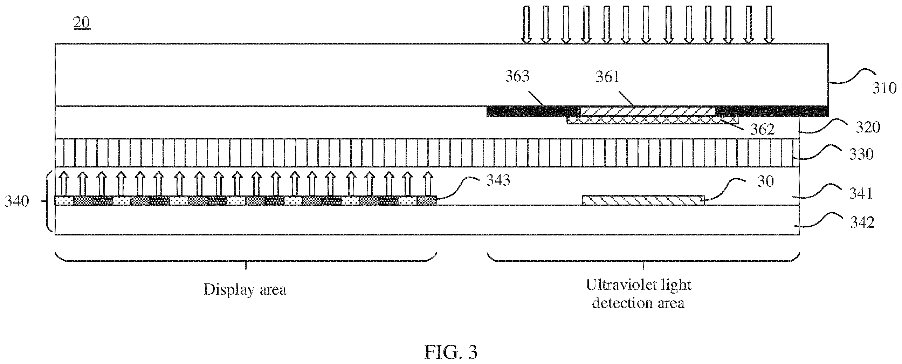

In FIG. 1 and FIG. 2, a local area of the display module 20 is circled by using a dashed line. FIG. 3 is a schematic diagram of a structure of the local area. The local area may include a part of the display area of the display module 20 and an ultraviolet light detection area of the display module 20. With reference to FIG. 1 to FIG. 3, the following describes a structure of the display module 20 according to an embodiment of this application.

The display module 20 may include a cover plate 310, an optical adhesive layer 320, a polarizer 330, and a display panel 340. The display panel 340 may include a front panel 341, a plurality of light emitting units 343, a backplane 342, and the light sensor 30. The cover plate 310, the optical adhesive layer 320, the polarizer 330, the front panel 341 of the display panel 340, and the backplane 342 of the display panel 340 may be distributed in the display area and the ultraviolet light detection area of the display module 20. The display area may be an area that is of the display module 20 and that is used to display an image. The ultraviolet light detection area may be an area used by the display module 20 to capture light from the outside. The light emitting units 343 may be distributed in the display area of the display module 20. The light sensor 30 may be distributed in the ultraviolet light detection area of the display module 20.

The backplane 342 of the display panel 340 may include an insulation material and a drive circuit of the light emitting unit 343. The drive circuit may be packaged in the insulation material. The insulation material may be, for example, glass or polyimide (polyimide, PI).

The light emitting unit 343 may be a light source of the display module 20. The light emitting unit 343 may be, for example, an organic light-emitting diode (organic light-emitting diode, OLED), an active-matrix organic light emitting diode (active-matrix organic light emitting diode, AMOLED), a flexible light-emitting diode (flexible light-emitting diode, FLED), a mini-LED, a micro-LED, and a micro-OLED. A powering status of the light emitting unit 343 is changed, so that the display module 20 can display a plurality of images.

The light emitting unit 343 may be disposed on the backplane 342 of the display panel 340, and is electrically connected to the drive circuit on the backplane 342. The electronic device 100 may control the light emitting unit 343 by using the drive circuit on the backplane 342, for example, drive the light emitting unit 343 to emit light, control a light emitting intensity of the light emitting unit 343, and extinguish the light emitting unit 343.

Light emitted by the light emitting unit 343 may pass through the front panel 341 of the display panel 340, to emit from the display panel 340. The front panel 341 may be configured to package the light emitting unit 343 and the backplane 342, to protect the light emitting unit 343.

The light emitted from the display panel 340 may pass through the polarizer 330 and the optical adhesive layer 320, to emit from the cover plate 310, so as to emit from the display module 20. For example, the polarizer 330 may be disposed on the display panel 340. The cover plate 310 and the polarizer 330 may be bonded together by using the optical adhesive layer 320. The polarizer 330 may be configured to change a polarization characteristic of light. The polarizer 330 may increase light scattering, to broaden a viewing angle of the display module 20. The polarizer 330 may further absorb ultraviolet light. The cover plate 310 and the optical adhesive layer 320 may have good transmittances. The cover plate 310 may provide a mechanical protection function for the display module 20. The cover plate 310 may further have another function, for example, a fingerprint prevention function. A main material of the cover plate 310 may be, for example, glass and colorless polyimide (colorless polyimide, CPI).

In some other embodiments, the display module 20 may further include a light absorption layer (not shown in FIG. 3). The light absorption layer may be, for example, foam or metal foil. The light absorption layer may be disposed on a side that is of the display panel 340 and that is away from the cover plate 310. Light from the outside may be emitted into the light absorption layer after passing through the display panel 340, and is absorbed by the light absorption layer. The light absorption layer helps block an internal structure of the electronic device 100.

Similar to the light emitting unit 343, the light sensor 30 may be packaged in the display panel 340. The light sensor 30 may be located between the backplane 342 of the display panel 340 and the front panel 341 of the display panel 340. This helps reduce cutting processes for the polarizer 330, the display panel 340, and the like, reduce process complexity, and improve space utilization. An orthographic projection of the light emitting unit 343 on the backplane 342 may not cross an orthographic projection of the light sensor 30 on the backplane 342. The orthographic projection of the light emitting unit 343 on the backplane 342 may be spaced from the orthographic projection of the light sensor 30 on the backplane 342. This helps reduce impact of light emitted by the light emitting unit 343 on the light sensor 30, and further helps reduce a possibility that the light sensor 30 interferes with the light emitted by the light emitting unit 343.

In the embodiment shown in FIG. 3, the display module 20 may further include an ultraviolet filter layer 361 and an ultraviolet light conversion layer 362. Light from the outside may be emitted into the display module 20, to emit into the ultraviolet filter layer 361. The ultraviolet filter layer 361 may be configured to: receive light emitted into the display module 20, and emit ultraviolet light filtered by the ultraviolet filter layer 361 to the ultraviolet light conversion layer 362. The ultraviolet light conversion layer 362 is configured to convert the ultraviolet light from the ultraviolet filter layer 361 into visible light or infrared light.

The ultraviolet filter layer 361 and the ultraviolet light conversion layer 362 may be located in the ultraviolet light detection area. The ultraviolet filter layer 361 and the ultraviolet light conversion layer 362 may be located on a side that is of the polarizer 330 and that is close to the cover plate 310. The ultraviolet filter layer 361 and the ultraviolet light conversion layer 362 may be, for example, located between the cover plate 310 and the polarizer 330. As shown in FIG. 3, the ultraviolet filter layer 361 may be disposed on the cover plate 310, and the ultraviolet light conversion layer 362 may be located between the ultraviolet filter layer 361 and the optical adhesive layer 320. In another possible embodiment, the ultraviolet light conversion layer 362 may be disposed on the polarizer 330, and the ultraviolet filter layer 361 may be located between the ultraviolet light conversion layer 362 and the optical adhesive layer 320.

To reduce a loss of ultraviolet light emitted into the ultraviolet light detection area, in some other embodiments of this application, a size of an orthographic projection of the ultraviolet light conversion layer 362 on the cover plate 310 may be greater than a size of an orthographic projection of the ultraviolet filter layer 361 on the cover plate 310. The orthographic projection of the ultraviolet filter layer 361 on the cover plate 310 may be located in the orthographic projection of the ultraviolet light conversion layer 362 on the cover plate 310. That is, an edge of the ultraviolet light conversion layer 362 may extend relative to an edge of the ultraviolet filter layer 361, so that light emitted from the edge of the ultraviolet filter layer 361 in a divergence form may be emitted into the ultraviolet light conversion layer 362 as much as possible. In addition, the ultraviolet light conversion layer 362 and the ultraviolet filter layer 361 may be attached to each other, to help reduce a loss of ultraviolet light emitted into the ultraviolet light detection area.

In some other embodiments, the display module 20 may further include a light shielding layer 363. The light shielding layer 363 may surround a periphery of the ultraviolet filter layer 361. The light shielding layer 363 may be configured to absorb light, for example, absorb visible light, ultraviolet light, and infrared light. Light irradiated around the ultraviolet filter layer 361 may be absorbed by the light shielding layer 363, and light irradiated in an area enclosed by the light shielding layer 363 may be emitted into the ultraviolet filter layer 361. In other words, light from the outside may be emitted into the light sensor 30 by using an area circled by the light shielding layer 363. In addition, light emitted by the light emitting unit 343 in the display panel 340 may diverge in a plurality of directions, and light emitted by the light emitting unit 343 close to the ultraviolet filter layer 361 may be reflected in an area that is of the cover plate 310 and that is close to the ultraviolet filter layer 361, and is emitted into the light sensor 30, thereby affecting detection of the light sensor 30. The light shielding layer 363 surrounding the periphery of the ultraviolet filter layer 361 is disposed, so that a small amount of light emitted by the light emitting unit 343 close to the ultraviolet filter layer 361 can be absorbed by the light shielding layer 363, thereby reducing impact of the light emitted by the light emitting unit 343 on ultraviolet light detection, and improving ultraviolet light detection accuracy.

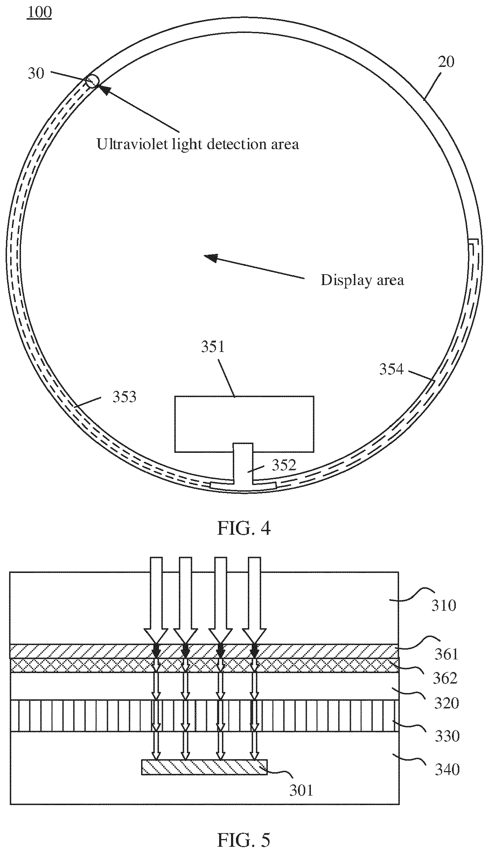

FIG. 4 shows a schematic diagram of a structure of an electronic device 100 according to an embodiment of this application by using a watch as an example. FIG. 4 shows an electrical connection solution inside the electronic device 100. For an electrical connection solution of another type of electronic device 100 (for example, a mobile phone), refer to the embodiment shown in FIG. 4.

With reference to FIG. 3 and FIG. 4, a first drive circuit 354 may be disposed on the backplane 342 of the display panel 340, and the first drive circuit 354 may be configured to drive the light emitting unit. The first drive circuit 354 may include a first circuit and a second circuit. A first end of the first circuit and a first end of the second circuit may be electrically connected to two ends of the light emitting unit separately. A second end of the first circuit and a second end of the second circuit may be electrically connected to two ends of a light emitting unit drive integrated circuit (integrated circuit, IC) separately.

With reference to FIG. 3 and FIG. 4, a second drive circuit 353 may be disposed on the backplane 342 of the display panel 340, and the second drive circuit 353 may be configured to drive the light sensor 30. A light sensor in the light sensor 30 is used as an example. The second drive circuit 353 may include a third circuit and a fourth circuit. A first end of the third circuit and a first end of the fourth circuit may be electrically connected to two ends of the light sensor separately. A second end of the third circuit and a second end of the fourth circuit may be electrically connected to two ends of a light sensor drive IC separately.

In the embodiment shown in FIG. 4, the electronic device 100 may include a circuit board 352 and a mainboard 351. The circuit board 352 may be electrically connected to the mainboard 351. The light emitting unit drive IC and the light sensor drive IC may be disposed on the mainboard 351. The second end of the first circuit, the second end of the second circuit, the second end of the third circuit, and the second end of the fourth circuit may be electrically connected to four pins of the circuit board 352 separately. The light emitting unit drive IC may control the light emitting unit by using the circuit board 352 and the first drive circuit 354. The light sensor drive IC may detect, by using the circuit board 352 and the second drive circuit 353, a signal output by the light sensor. In the embodiment shown in FIG. 4, the circuit board 352 may be, for example, a flexible printed circuit (flexible printed circuit, FPC) 352.

FIG. 5 shows a schematic diagram of a structure of the ultraviolet light detection area shown in FIG. 3. With reference to FIG. 3 and FIG. 5, the following describes an embodiment of a display module 20 provided in an embodiment of this application by using an example in which the display panel 340 has one light sensor (for example, a first light sensor 301). The following describes a light conversion principle of the display module 20 by using visible light and ultraviolet light as an example. For a principle of converting light (for example, infrared light) of another wavelength by the display module 20, refer to a principle of converting visible light by the display module 20.

Light (for example, including visible light and ultraviolet light, where in this application, the visible light is shown by a white arrow, and the ultraviolet light may be shown by a black arrow) from the outside may be emitted into the ultraviolet filter layer 361 after passing through the cover plate 310. The ultraviolet filter layer 361 may belong to an ultraviolet filter structure. The ultraviolet filter layer 361 may be configured to: transmit ultraviolet light, and absorb or reflect light (for example, visible light) of another wavelength. For example, the ultraviolet filter layer 361 may be configured to: enable at least some light of a wavelength of 200 to 400 nm to pass through the ultraviolet filter layer 361, and absorb or reflect at least a majority of light of a wavelength of 400 to 1000 nm. A specific wavelength of ultraviolet light that can pass through the ultraviolet filter layer 361 may not be limited in this embodiment of this application. In this embodiment of this application, a specific wavelength of light that is other than ultraviolet light and that can be absorbed or reflected by the ultraviolet filter layer 361 may not be limited.

At least a large part of light emitted from the ultraviolet filter layer 361 is ultraviolet light. The light emitted from the ultraviolet filter layer 361 may be emitted into the ultraviolet light conversion layer 362. The ultraviolet light conversion layer 362 may be configured to convert the ultraviolet light from the ultraviolet filter layer 361 into visible light.

The ultraviolet light conversion layer 362 may be, for example, a type of ink. For example, the ultraviolet light conversion layer 362 may use an organic fluorescent material or an inorganic fluorescent material, for example, yttrium aluminum garnet (yttrium aluminum garnet, YAG) powder or a β sailon (βSailon) fluorescent body.

The visible light emitted from the ultraviolet light conversion layer 362 may pass through the polarizer 330 and the front panel 341 of the display panel 340, and be emitted into the first light sensor 301.

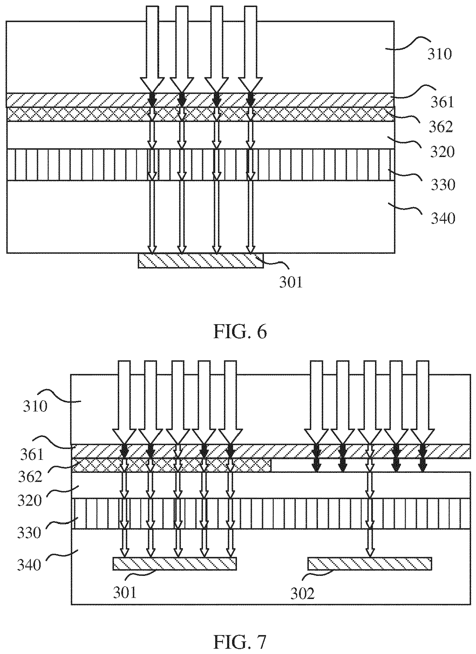

FIG. 6 shows a schematic diagram of another structure of the ultraviolet light detection area. Different from the structure of the ultraviolet light detection area shown in FIG. 5, the first light sensor 301 shown in FIG. 6 may not be packaged in the display panel 340. The first light sensor 301 and the light emitting unit 343 may be separately disposed on two sides of the backplane 342 of the display panel 340. For example, the first light sensor 301 may be disposed in a through hole of the light absorption layer.

Because a drive circuit for supplying power to the light emitting unit 343 is disposed on a side that is of the backplane 342 and that faces the front panel 341 of the display panel 340, and the first light sensor 301 is disposed on a side that is of the backplane 342 and that is away from the front panel 341, it is helpful to reduce cabling complexity of a drive circuit for driving the first light sensor 301.

FIG. 7 shows a schematic diagram of another structure of the ultraviolet light detection area shown in FIG. 3 and FIG. 4. With reference to FIG. 3, FIG. 4, and FIG. 7, the following describes an embodiment of a display module 20 provided in an embodiment of this application by using an example in which the display panel 340 includes two light sensors (the two light sensors are respectively a first light sensor 301 and a second light sensor 302). For a manner of disposing the second light sensor 302 in the electronic device 100, refer to the first light sensor 301.

Based on a quantity of the plurality of light sensors 30, the ultraviolet light detection area of the display module 20 may be divided into a plurality of areas, and the plurality of areas may be in a one-to-one correspondence with the plurality of light sensors 30. The light sensor 30 may detect a light intensity of light emitted into a corresponding area. The ultraviolet light detection area may include a first area and a second area. The first area of the ultraviolet light detection area may alternatively be referred to as a primary ultraviolet light detection area. The second area of the ultraviolet light detection area may be a reference area of the first area of the ultraviolet light detection area. The first light sensor 301 may be disposed corresponding to the first area of the ultraviolet light detection area, to detect a light intensity of light emitted into the first area of the ultraviolet light detection area. The second light sensor 302 may be disposed corresponding to the second area of the ultraviolet light detection area, to detect a light intensity of light emitted into the second area of the ultraviolet light detection area.

The ultraviolet filter layer 361 may be distributed in the first area and the second area of the ultraviolet light detection area. The ultraviolet light conversion layer 362 may be disposed in the first area of the ultraviolet light detection area, and is not distributed in the second area of the ultraviolet light detection area. The first area and the second area of the ultraviolet light detection area may be obtained through dividing based on a position of the ultraviolet light conversion layer 362 in the ultraviolet light detection area.

A first part of light emitted from the outside may be irradiated in the first area of the ultraviolet light detection area. The first part of light may include visible light and ultraviolet light. In some embodiments of this application, the first part of light may further include light of another wavelength, for example, infrared light. The following describes a light conversion principle of the display module 20 by using visible light and ultraviolet light of the first part of light as an example. For a principle of converting light (for example, infrared light) of another wavelength of the first part of light by the display module 20, refer to a principle of converting visible light of the first part of light by the display module 20.

The visible light and the ultraviolet light of the first part of light may be irradiated in a first part of the ultraviolet filter layer 361. The first part of the ultraviolet filter layer 361 may correspond to the first area of the ultraviolet light detection area. At least a part (for example, more than 20%) of ultraviolet light of the first part of light may pass through the first part of the ultraviolet filter layer 361. Most visible light of the first part of light may be absorbed or reflected by the first part of the ultraviolet filter layer 361. A small amount (for example, less than 5%) of visible light of the first part of light may pass through the first part of the ultraviolet filter layer 361. A proportion of visible light that passes through the first part of the ultraviolet filter layer 361 may be less than a proportion of ultraviolet light that passes through the ultraviolet filter layer 361. Therefore, the light emitted from the first part of the ultraviolet filter layer 361 may include ultraviolet light and visible light. The light emitted from the first part of the ultraviolet filter layer 361 may be mainly ultraviolet light.

The first part of the ultraviolet filter layer 361 is configured to emit light filtered by the first part of the ultraviolet filter layer 361 to the ultraviolet light conversion layer 362. That is, the ultraviolet light and the visible light emitted from the first part of the ultraviolet filter layer 361 may be emitted into the ultraviolet light conversion layer 362. The ultraviolet light conversion layer 362 may convert the ultraviolet light from the first part of the ultraviolet filter layer 361 into visible light. The visible light from the first part of the ultraviolet filter layer 361 may pass through the ultraviolet light conversion layer 362. The light emitted from the ultraviolet light conversion layer 362 may include visible light obtained by converting ultraviolet light, and visible light that is emitted into and passes through the ultraviolet light conversion layer 362.

The first light sensor 301 may be disposed opposite to the first part of the ultraviolet filter layer 361. The visible light emitted from the ultraviolet light conversion layer 362 may be emitted into the first light sensor 301 through the polarizer 330. A first part of visible light detected by the first light sensor 301 may correspond to the ultraviolet light that passes through the first part of the ultraviolet filter layer 361, and a second part of visible light detected by the first light sensor 301 may correspond to the visible light that passes through the first part of the ultraviolet filter layer 361.

A second part of light emitted from the outside may be irradiated in the second area of the ultraviolet light detection area. The second part of light may include visible light and ultraviolet light. In some embodiments of this application, the second part of light may further include light of another wavelength, for example, infrared light. The following describes a light conversion principle of the display module 20 by using visible light and ultraviolet light of the second part of light as an example. For a principle of converting light (for example, infrared light) of another wavelength of the second part of light by the display module 20, refer to a principle of converting visible light of the second part of light by the display module 20.

The visible light and the ultraviolet light of the second part of light may be irradiated in a second part of the ultraviolet filter layer 361. The second part of the ultraviolet filter layer 361 may correspond to the second area of the ultraviolet light detection area. At least a part of ultraviolet light of the second part of light may pass through the second part of the ultraviolet filter layer 361. Most visible light of the second part of light may be absorbed or reflected by the second part of the ultraviolet filter layer 361. A small amount of visible light of the second part of light may pass through the second part of the ultraviolet filter layer 361. A proportion of visible light that passes through the second part of the ultraviolet filter layer 361 may be less than a proportion of ultraviolet light that passes through the second part of the ultraviolet filter layer 361. Therefore, the light emitted from the second part of the ultraviolet filter layer 361 may include ultraviolet light and visible light.

An orthographic projection of the ultraviolet light conversion layer 362 on the ultraviolet filter layer 361 may be located outside the second part of the ultraviolet filter layer 361. In other words, no ultraviolet light conversion layer 362 may be disposed in the second area of the ultraviolet light detection area. Therefore, the ultraviolet light and the visible light from the second part of the ultraviolet filter layer 361 may be emitted into the polarizer 330. The polarizer 330 may absorb the ultraviolet light and transmit the visible light. The second light sensor 302 may be disposed opposite to the second part of the ultraviolet filter layer 361. In the second area of the ultraviolet light detection area, the visible light emitted from the polarizer 330 may be emitted into the second light sensor 302. Visible light detected by the second light sensor 302 may correspond to visible light that passes through the second part of the ultraviolet filter layer 361.

The first light sensor 301 detects the visible light that passes through the first part of the ultraviolet filter layer 361. Consequently, an error may exist in a light intensity of ultraviolet light detected by the first light sensor 301. That is, in addition to detecting external ultraviolet, the first light sensor 301 further detects a small amount of external visible light, so that the light intensity of the ultraviolet light detected by the first light sensor 301 is relatively high. Because the second light sensor 302 may detect the visible light that passes through the second part of the ultraviolet filter layer 361, if a detection result of the first light sensor 301 and a detection result of the second light sensor 302 are combined to output an ultraviolet light intensity, a detection error of the ultraviolet light intensity may be reduced.

It is assumed that a current output by the first light sensor 301 is $I_1$, where $I_1=I_{1,UV}+I_{1,VL}$. $I_{1,UV}$ corresponds to the ultraviolet light that passes through the first part of the ultraviolet filter layer 361. $I_{1,VL}$ corresponds to the visible light that passes through the first part of the ultraviolet filter layer 361. It is assumed that a current output by the second light sensor 302 is $I_2$, where $I_2=I_{2,VL}$. $I_{2,VL}$ corresponds to the visible light that passes through the second part of the ultraviolet filter layer 361. A light intensity of external ultraviolet light that is inferred by combining $I_{1,VL}$ and $I_{2,VL}$ may be more easily to match a real ultraviolet light intensity.

The current $I_1$ output by the first light sensor 301 may be related to an ultraviolet light transmittance Tuv of the ultraviolet filter layer 361, conversion efficiency $\eta_{UV}$ of the ultraviolet light conversion layer 362, a visible light transmittance $T_{POL}$ of the polarizer 330, optical-to-electrical conversion efficiency $E_1$ of the first light sensor 301, and the like. The current $I_2$ output by the second light sensor 302 may be related to the ultraviolet light transmittance Tuv of the ultraviolet filter layer 361, the visible light transmittance $T_{POL}$ of the polarizer 330, optical-to-electrical conversion efficiency $E_2$ of the second light sensor 302, and the like.

It is assumed that a light intensity of ultraviolet light emitted into a part that is of the ultraviolet filter layer 361 and that corresponds to the first light sensor 301 is $L_{0,UV}$.

A light intensity of light output by the part that is of the ultraviolet filter layer 361 and that corresponds to the first light sensor 301 is $L_1$, $L_1=L_{1,UV}+L_{1,VL}$, $L_{1,UV}=L_{0,UV}\times T_{UV}$, $L_{1,UV}$ is a light intensity of ultraviolet light output by the part that is of the ultraviolet filter layer 361 and that corresponds to the first light sensor 301, and $L_{1,VL}$ is a light intensity of visible light output by the part that is of the ultraviolet filter layer 361 and that corresponds to the first light sensor 301. In this case, a light intensity of light output by the ultraviolet light conversion layer 362 is $L_2$, and $L_2=L_{1,UV}\times\eta_{UV}+L_{1,VL}$. A light intensity of light output by a part that is of the polarizer 330 and that corresponds to the first light sensor 301 is $L_3$, and $L_3=(L_{1,UV}\times\eta_{UV}+L_{1,VL})\times T_{POL}$. The current output by the first light sensor 301 is $I_1$, and $I_1=L_3\times E_1=(L_{1,UV}\times\eta_{UV}+L_{1,VL})\times T_{POL}\times E_1$.

A light intensity $L_4$ of light output by a part that is of the ultraviolet filter layer 361 and that corresponds to the second light sensor 302 is equal to $L_{2,UV}+L_{2,VL}$, $L_{2,UV}=L_{0,UV}\times T_{UV}$, $L_{2,UV}$ is a light intensity of ultraviolet light output by the part that is of the ultraviolet filter layer 361 and that corresponds to the second light sensor 302, and $L_{2,VL}$ is a light intensity of visible light output by the part that is of the ultraviolet filter layer 361 and that corresponds to the second light sensor 302. The polarizer 330 may absorb ultraviolet light. Therefore, a light intensity of light output by a part that is of the polarizer 330 and that corresponds to the second light sensor 302 is $L_5$, where $L_5=L_{2,VL}\times T_{POL}$. The current $I_2$ output by the second light sensor 302 is equal to $L_{2,VL}\times T_{POL}\times E_2$.

Assuming that $L_{1,VL}$ and $L_{2,VL}$ are the same, and $E_1$ and $E_2$ are the same, $I_1-I_2=L_{0,UV}\times T_{UV}\times\eta_{UV}\times T_{POL}\times E_1$. Therefore, $L_{0,UV}=(I_1-I_2)/(T_{UV}\times\eta_{UV}\times T_{POL}\times E_1)$.

If a visible light transmittance $T_{VL}$ of the ultraviolet light conversion layer is further considered, $L_2=L_{1,UV}\times\eta_{UV}+L_{1,VL}\times T_{VL}$, $L_3=(L_{1,UV}\times\eta_{UV}+L_{1,VL}\times T_{VL})\times T_{POL}$, and $I_1=(L_{1,UV}\times\eta_{UV}+L_{1,VL}\times T_{VL})\times T_{POL}\times E_1$. Assuming that $L_{1,VL}$ and $L_{2,VL}$ are the same, and $E_1$ and $E_2$ are the same, $I_1-T_{VL}\times I_2=L_{0,UV}\times T_{UV}\times\eta_{UV}\times T_{POL}\times E_1$. Therefore, $L_{0,UV}=(I_1-T_{VL}\times I_2)/(T_{UV}\times\eta_{UV}\times T_{POL}\times E_1)$.

Through a series of settings, the visible light that passes through the ultraviolet filter layer 361 and that is detected by the first light sensor 301 may be as the same as the visible light that passes through the ultraviolet filter layer 361 and that is detected by the second light sensor 302 as possible. For example, a half of the ultraviolet filter layer 361 is attached to the ultraviolet light conversion layer 362, and the other half is located outside the ultraviolet light conversion layer 362 (that is, a part that is of the ultraviolet filter layer 361 and that is attached to the ultraviolet light conversion layer 362 is a part 1, and a part that is of the ultraviolet filter layer 361 and that is located outside the ultraviolet light conversion layer 362 is a part 2, and a size of an orthographic projection of the part 1 on the polarizer 330 is the same as a size of an orthographic projection of the part 2 on the polarizer 330). For another example, a light sensitive parameter of the first light sensor 301 is the same as a light sensitive parameter of the second light sensor 302.

The ultraviolet filter layer 361 may alternatively be implemented by a plurality of ultraviolet filter components. For example, the first light sensor 301 may be disposed opposite to a first ultraviolet filter component, and the second light sensor 302 may be disposed opposite to a second ultraviolet filter component. The first ultraviolet filter component and the second ultraviolet filter component may be the same in terms of a size parameter, a light filter parameter, and the like. Ultraviolet light emitted from the second ultraviolet filter component may not pass through the ultraviolet light conversion layer 362 as far as possible.

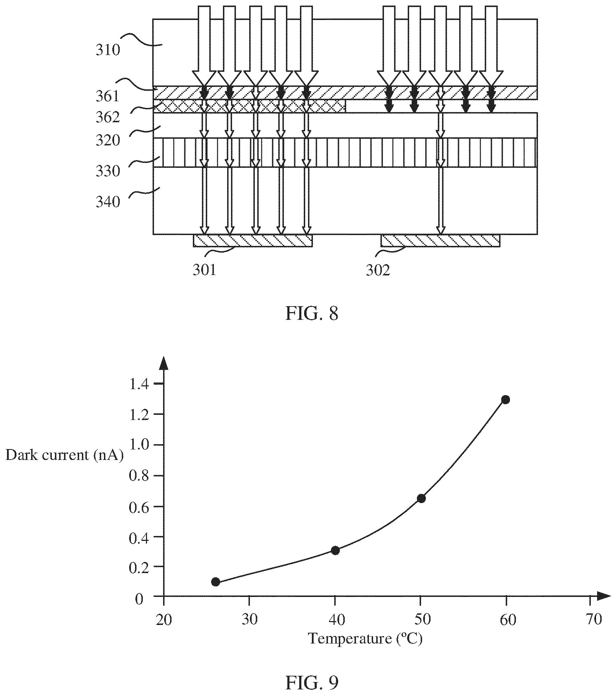

FIG. 8 shows a schematic diagram of another structure of the ultraviolet light detection area. Different from the structure of the ultraviolet light detection area shown in FIG. 7, the first light sensor 301 and the second light sensor 302 shown in FIG. 8 may not be packaged in the display panel 340. The first light sensor 301 and the light emitting unit 343 may be separately disposed on two sides of the backplane 342 of the display panel 340, and the second light sensor 302 and the light emitting unit 343 may be separately disposed on two sides of the backplane 342 of the display panel 340. For example, the first light sensor 301 and the second light sensor 302 may be disposed in a through hole of the light absorption layer.

Because a drive circuit for supplying power to the light emitting unit 343 is disposed on a side that is of the backplane 342 and that faces the front panel 341 of the display panel 340, and the first light sensor 301 and the second light sensor 302 are disposed on a side that is of the backplane 342 and that is away from the front panel 341, it is helpful to reduce cabling complexity of a drive circuit for driving the first light sensor 301 and the second light sensor 302.

When no light is irradiated in the light sensor 30, a current may be conducted in the light sensor 30. This current may alternatively be referred to as a dark current. As shown in FIG. 9, a magnitude of the dark current flowing in the light sensor 30 may be related to temperature of the light sensor 30. In the embodiments shown in FIG. 5 and FIG. 6, one light sensor, namely, the first light sensor 301, may be disposed on the ultraviolet light detection area. The current conducted in the first light sensor 301 may include a dark current and an effective current generated because of ultraviolet light detection. Existence of the dark current may affect detection accuracy of the first light sensor 301.

In the embodiments shown in FIG. 7 and FIG. 8, two light sensors, namely, the first light sensor 301 and the second light sensor 302, may be disposed in the ultraviolet light detection area. Both a current flowing in the first light sensor 301 and a current flowing in the second light sensor 302 may include a dark current. Therefore, disposing two light sensors in the display module 20 further helps reduce impact of the dark current on ultraviolet light detection accuracy.

In some embodiments, the ultraviolet light conversion layer 362 may convert the ultraviolet light into a specific color, for example, into blue light, green light, or red light. To reduce impact of other light on a detection result of the light sensor 30 (for example, the first light sensor 301 in FIG. 5 to FIG. 8), the light sensor 30 may detect light of a specific color. A wavelength of light detected by the light sensor 30 matches a wavelength of light obtained through conversion by the ultraviolet light conversion layer 362. For example, a wavelength range of the light detected by the light sensor 30 and a wavelength range of the light obtained through conversion by the ultraviolet light conversion layer 362 overlap each other.

In some other embodiments, the ultraviolet light conversion layer 362 may convert ultraviolet light of different wavelengths into visible light of a plurality of wavelengths. For example, UVC of a wavelength of 200 to 280 nm is converted into visible light of a wavelength -1, UVB of a wavelength of 280 to 315 nm is converted into visible light of a wavelength -2, and UVA of a wavelength of 315 to 400 nm is converted into visible light of a wavelength -3. The wavelength -1, the wavelength -2, and the wavelength -3 can be different from each other. For example, the wavelength -1, the wavelength -2, and the wavelength -3 may respectively correspond to red light, blue light, and green light. Correspondingly, a light sensor 30-1, a light sensor 30-2, and a light sensor 30-3 may be disposed in the electronic device 100. The light sensor 30-1 may be configured to detect light of the wavelength -1, the light sensor 30-2 may be configured to detect light of the wavelength -2, and the light sensor 30-3 may be configured to detect light of the wavelength -3. Therefore, the electronic device 100 may have a capability of detecting a plurality of types of ultraviolet light. In some embodiments of this application, the light sensor 30-1, the light sensor 30-2, and the light sensor 30-3 may be alternatively replaced with a light sensitive unit -1, a light sensitive unit -2, and a light sensitive unit -3 of the light sensor 30.

In some embodiments of this application, to enable the ultraviolet light conversion layer 362 to convert ultraviolet light of different wavelengths into visible light of a plurality of wavelengths, the ultraviolet light conversion layer 362 may include a plurality of ultraviolet light conversion components. For example, each ultraviolet light conversion component may be configured to convert ultraviolet light of a corresponding wavelength into visible light of a corresponding wavelength. The plurality of ultraviolet light conversion components may correspond to different ultraviolet light wavelengths, and the plurality of ultraviolet light conversion components may correspond to different visible light wavelengths.

Because different types of ultraviolet light have different impact on a human body, detecting a plurality of types of ultraviolet light helps the electronic device 100 provide an appropriate sun protection policy for a user based on a type of external ultraviolet light.

With reference to the embodiments shown in FIG. 5 to FIG. 8, the following describes several ultraviolet filter layers 361 provided in embodiments of this application. The following describes a light filter principle of the ultraviolet filter layer 361 by using a conversion mode in which visible light and ultraviolet light pass through the ultraviolet filter layer 361. For a conversion mode in which infrared light passes through the ultraviolet filter layer 361, refer to a conversion mode in which the visible light passes through the ultraviolet filter layer 361.

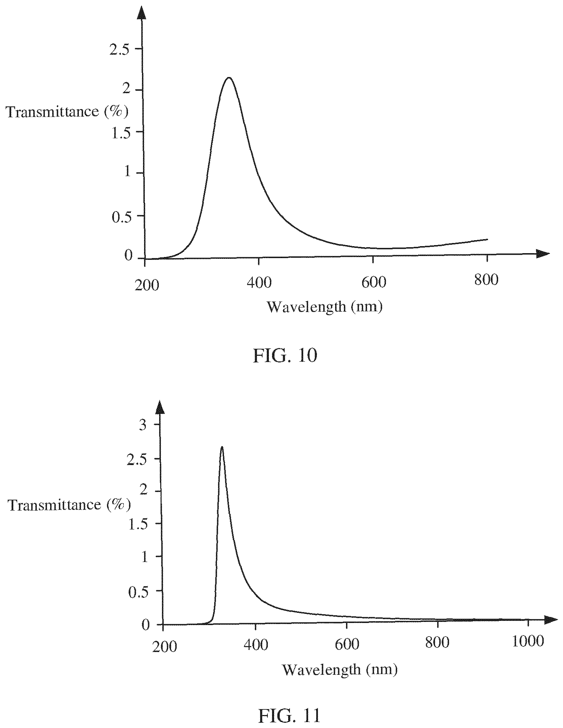

In some embodiments, the ultraviolet filter layer 361 may be black ultraviolet filter ink. The ultraviolet filter ink may include materials such as inorganic metal particles, carbon black, and resin. For light filter performance of the ultraviolet filter ink, refer to the embodiment shown in FIG. 10. In the embodiment shown in FIG. 10, such black ultraviolet filter ink may absorb most visible light (for example, an absorption wavelength is greater than 500 nm). An ultraviolet light transmittance/a visible light transmittance may be, for example, greater than 10. The ultraviolet filter ink may be obtained, for example, through spraying or printing.

With reference to FIG. 10, in some scenarios, the ultraviolet filter ink may transmit a small part of visible light. For example, a small part of visible light of a wavelength of 400 to 500 nm may pass through the ultraviolet filter ink. A light intensity of visible light emitted into the cover plate 310 is generally greater than a light intensity of ultraviolet light emitted into the cover plate 310. Therefore, even if only a small part of visible light may pass through the ultraviolet filter layer 361, ultraviolet light detection accuracy is prone to be affected. More visible light transmitted by the ultraviolet filter layer 361 indicates that a detection result of ultraviolet light may be more inaccurate.

In some other embodiments, the ultraviolet filter layer 361 may alternatively be a silver nano-silver film. The nano-silver film may be a material mainly made of nano-scale silver. For light filter performance of the nano-silver film, refer to the embodiment shown in FIG. 11. In the embodiment shown in FIG. 11, the nano-silver film may absorb most visible light (for example, absorb light of a wavelength greater than 350 to 400 nm or light of a wavelength less than 250 nm). An ultraviolet light transmittance/a visible light transmittance may be, for example, greater than 10. The nano-silver film may be obtained, for example, through spraying or printing.

Because of a color of the nano-silver film, the nano-silver film has light reflection. Light from the outside may be reflected by the nano-silver film and then emitted into an eye of a user. As a result, the user may observe the nano-silver film from an appearance of the electronic device 100, and normal observation of the display area of the display module 20 by the user may be easily affected. When a light intensity of external light is strong, the nano-silver film may reflect strong light, which may damage the eye of the user.

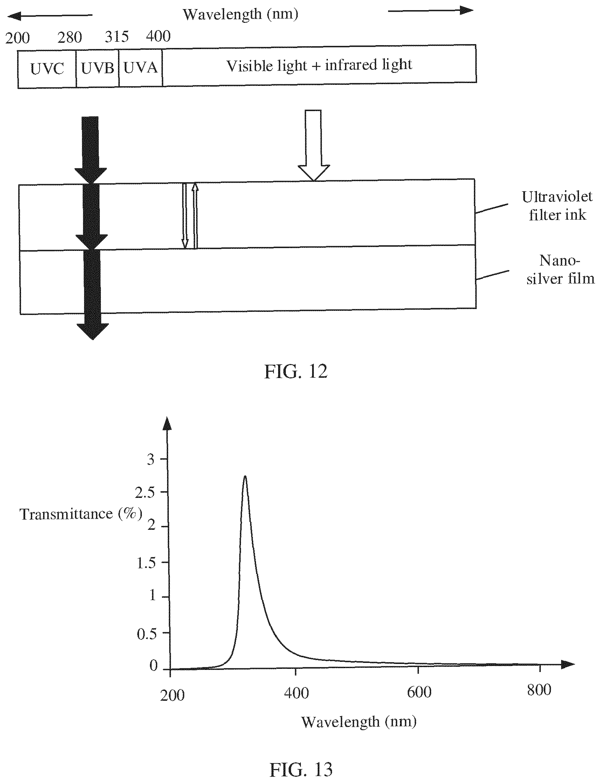

In some other embodiments, the ultraviolet filter layer 361 may be obtained by superposing the ultraviolet filter ink shown in FIG. 10 and the nano-silver film shown in FIG. 11. FIG. 12 shows a light filter principle of the ultraviolet filter layer 361.

Light from the outside can pass through the ultraviolet filter ink and then enter the nano-silver film. The nano-silver film may be located on a side that is of the ultraviolet filter ink and that is close to the polarizer 330. Ultraviolet light from the outside (for example, a part of UVC of a wavelength of 200 to 280 nm, a part of UVB of a wavelength of 280 to 315 nm, and a part of UVA with a wavelength of 315 to 400 nm) can pass through the ultraviolet filter ink. A small part of visible light (for example, a part of visible light of a wavelength of 400 to 500 nm) may pass through the ultraviolet filter ink. Other light (for example, most visible light and infrared light) emitted into the ultraviolet filter ink may be absorbed by the ultraviolet filter ink.

Light emitted into the nano-silver film may include ultraviolet light and a small part of visible light from the ultraviolet filter ink. Because the nano-silver film can absorb or reflect visible light of a wavelength greater than 400 nm, light transmitted by the nano-silver film is almost ultraviolet light. The nano-silver film can absorb or reflect the small part of visible light from the ultraviolet filter ink. Visible light reflected by the nano-silver film can be emitted into the ultraviolet filter ink and absorbed by the ultraviolet filter ink.

FIG. 13 shows light filter performance of the ultraviolet filter layer 361 obtained by superimposing the ultraviolet filter ink and the nano-silver film. In the embodiment shown in FIG. 13, the ultraviolet filter layer 361 can absorb or filter out most visible light (for example, absorb light of a wavelength greater than 350 to 400 nm), so that ultraviolet light that passes through the ultraviolet filter layer 361 may be more pure. For example, an ultraviolet light transmittance/a visible light transmittance may be greater than 40.

In the foregoing embodiment, the ultraviolet filter layer 361 may be obtained through spraying, printing, or the like. Therefore, processing difficulty of the ultraviolet filter layer 361 is low.

In still some embodiments, the cover plate 310 may have a function similar to that of the ultraviolet filter layer 361. For example, the cover plate 310 may be optical glass with an ultraviolet filter function. A plurality of layers of inorganic materials with different refractive indexes are evaporated in the glass, so that the cover plate 310 can have an ultraviolet filter function. Therefore, the cover plate 310 may be an ultraviolet filter structure. In a possible scenario, the ultraviolet filter layer 361 may be omitted from the display module 20. For example, the ultraviolet light conversion layer 362 may be directly disposed on the cover plate 310. In another possible scenario, the cover plate 310 with the ultraviolet filter function may be superimposed with the ultraviolet filter layer 361 in the foregoing embodiment, so that ultraviolet light emitted into the ultraviolet light conversion layer 362 may be more pure.

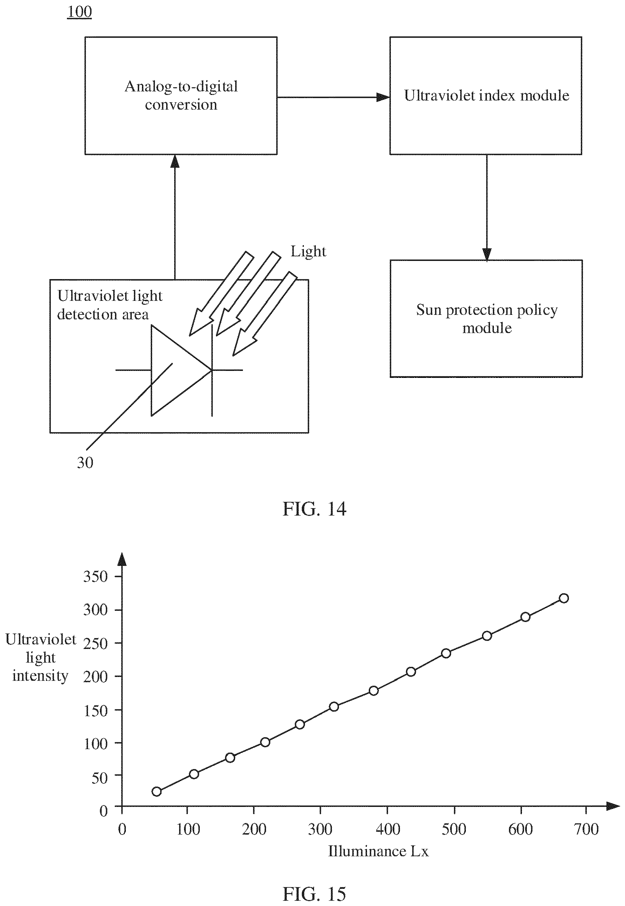

FIG. 14 is a schematic diagram of a software architecture of an electronic device 100 according to an embodiment of this application.

With reference to the foregoing embodiment, external light may be irradiated in an ultraviolet light detection area of the electronic device 100. The electronic device 100 may determine a light intensity of ultraviolet light in the external light by using a light sensor 30. The electronic device 100 may convert, by using an analog-to-digital conversion module, a current signal flowing in the light sensor 30 into a digital signal, to obtain a value of a current flowing in the light sensor 30. The electronic device 100 may determine, by using an ultraviolet index module, a light intensity of light irradiated in the light sensor 30, that is, obtain an illuminance (Lx) value, and determine an ultraviolet (UV) index based on the illuminance value.

For example, an ultraviolet index at night may be 0. If the ultraviolet index is 1 or 2, it can be inferred that current weather is cloudy or rainy. In this case, an ultraviolet intensity is very weak. If the ultraviolet index is 3 or 4, it can be inferred that current weather is cloudy. In this case, an ultraviolet intensity is relatively weak. If the ultraviolet index is 5 or 6, it can be inferred that current weather is of few cloud. In this case, an ultraviolet intensity is relatively strong. If the ultraviolet index is 7 to 9, it can be inferred that current weather is sunny and cloudless. In this case, an ultraviolet intensity is very strong. If the ultraviolet index is 10 or above 10, it can be inferred that current weather is sun exposure (such as a summer sunny day), and an ultraviolet intensity is extremely strong.

According to the solution provided in this embodiment of this application, a schematic diagram shown in FIG. 15 may be obtained based on a relationship between illuminance obtained by the light sensor 30 and a light intensity of external ultraviolet light. The illuminance Lx value obtained by the light sensor 30 in this embodiment of this application may be in a linear relationship with the light intensity of the external ultraviolet light, which means that the light intensity of the external ultraviolet light can be accurately deduced according to the solution provided in this embodiment of this application, to obtain an accurate ultraviolet index.

The electronic device 100 may further prompt, by using a sun protection policy module, a user with an appropriate sun protection policy according to an obtained ultraviolet indication.

In some embodiments, the electronic device 100 may indicate a current UV index by using a user interface. In some other embodiments, the electronic device 100 may further display a recommended sun protection policy in the user interface for a current UV index. This helps to reduce damage of high-intensity ultraviolet to the user.

In a possible case, the electronic device 100 may automatically display information related to the UV index. For example, in response to a wake-up operation performed by the user on the electronic device 100, the electronic device 100 may be woken up, and a main interface is displayed in the user interface. The main interface may include controls of a plurality of applications. The main interface may include, for example, a weather control, and the weather control may display the information related to the UV index.

In another possible case, the electronic device 100 may be triggered by the user to display information related to the UV index. The electronic device 100 may display a control of an application related to the UV index. The electronic device 100 may respond to an operation performed by the user on the control of the application, and enable an interface of the application, to display the information related to the UV index.

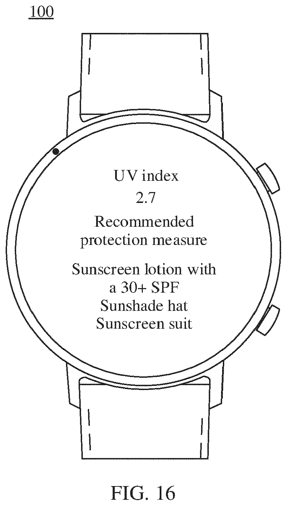

As shown in FIG. 16, the electronic device 100 may display an accurate UV index. In the embodiment shown in FIG. 16, a current UV index is 2.7, and a recommended protection measure may include, for example, applying sunscreen lotion with a 30+ sun protection factor (sun protection factor, SPF), wearing a sunshade hat, and wearing a sunscreen suit.

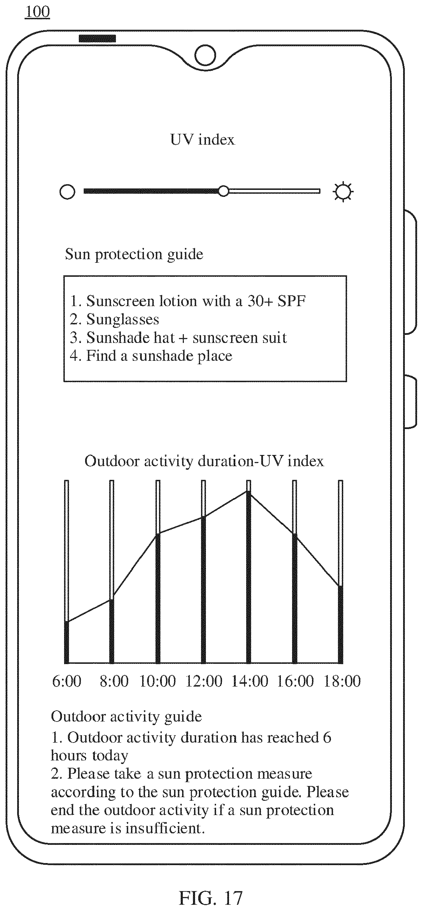

As shown in FIG. 17, the electronic device 100 may further roughly indicate the UV index by using a UV control and a UV indicator bar. For example, a first end of the UV indicator bar may correspond to a low UV index, and a second end of the UV indicator bar may correspond to a high UV index. The UV control is located at a position on the UV indicator bar. Distance between the UV control and the two ends of the UV indicator bar reflect the UV index. When the UV control is close to the first end of the UV indicator bar, it may indicate a lower current UV index, and when the UV control is close to the second end of the UV indicator bar, it may indicate a higher current UV index.

For the UV index shown in FIG. 17, a recommended protection measure may include, for example, applying sunscreen lotion with a 30+ SPF, wearing sunglasses, wearing a sunshade hat, wearing a sunscreen suit, and staying in a cool place as much as possible.

In some other embodiments, the electronic device 100 may indicate a historical UV index by using the user interface.

As shown in FIG. 17, the electronic device 100 may record UV indices at a plurality of moments, and display the UV indices at the plurality of moments in the user interface. In the embodiment shown in FIG. 17, a UV index corresponding to 14:00 may be the highest. A UV index corresponding to 6:00 may be the lowest. From 6:00 to 14:00, the UV index may increase gradually. From 14:00 to 18:00, the UV index may decrease gradually.

The historical UV index may further indicate outdoor activity duration to the user.

In the embodiment shown in FIG. 17, the UV index may be low in 6:00 to 10:00 and 16:00 to 18:00, and may be high in 10:00 to 16:00. Therefore, it can be inferred that the outdoor activity duration of the user may be greater than 6 hours.

The electronic device 100 may further provide guidance or suggestions based on the outdoor activity duration.

An outdoor activity guide is displayed in the user interface shown in FIG. 17. In the embodiment shown in FIG. 17, the outdoor activity duration of the user is long. If the user has taken protection measures according to the sun protection guide, the user may suffer from small ultraviolet damage. The electronic device may advise the user to determine, based on a situation of the user, whether to continue an outdoor activity. If the user does not take protection measures according to the sun protection guide, the user may suffer from large ultraviolet damage. The electronic device may advise the user to end the outdoor activity as soon as possible.

According to the solution provided in this application, the electronic device or the display module can accurately detect a light intensity of external ultraviolet light, and can provide an appropriate ultraviolet light prevention policy for a user.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A display module, comprising an ultraviolet filter structure, an ultraviolet light conversion layer, a polarizer, and a display panel that are disposed in a stacked manner, wherein the ultraviolet light conversion layer is located between the ultraviolet filter structure and the polarizer, and the display panel is located on a side that is of the polarizer and that is away from the ultraviolet filter structure;

   the display panel comprises a light emitting unit, a first light sensor, a front panel, and a backplane, wherein the light emitting unit is located between the front panel and the backplane, the first light sensor is located between the front panel and the backplane, and an orthographic projection of the light emitting unit on the backplane does not cross an orthographic projection of the first light sensor on the backplane;
   light emitted by the light emitting unit is configured to be emitted from the display module through the polarizer; the ultraviolet filter structure is configured to: receive light emitted into the display module, and emit ultraviolet light filtered by the ultraviolet filter structure;
   the ultraviolet light conversion layer is configured to convert the ultraviolet light from the ultraviolet filter structure into visible light or infrared light, and the light emitted from the ultraviolet light conversion layer is configured to be emitted into the first light sensor through the polarizer; and
   the first light sensor is configured to detect a light intensity of the light from the polarizer.

2. The display module according to claim 1, wherein the ultraviolet filter structure comprises a first part and a second part, the first part is configured to emit light filtered by the first part to the ultraviolet light conversion layer, the second part is configured to emit light filtered by the second part to the polarizer, an orthographic projection of the ultraviolet light conversion layer on the ultraviolet filter structure is located outside the second part, and the first light sensor is disposed opposite to the first part; and the display module further comprises:
   a second light sensor, wherein the second light sensor is located on the side that is of the polarizer and that is away from the ultraviolet filter structure, and is disposed opposite to the second part, and the second light sensor is configured to detect the light intensity of the light from the polarizer.

3. The display module according to claim 2, wherein a current flowing in the first light sensor is $I_1$, a current flowing in the second light sensor is $I_2$, and a light intensity $L_{0,UV}$ of external ultraviolet light satisfies:

$$L_{0,UV} = (I_1 - k_1 \times I_2)/k_2,$$

   wherein

   $k_1$ is 1 or $T_{VL}$, and $T_{VL}$ is a visible light transmittance or an infrared light transmittance of the ultraviolet light conversion layer; and
   $k_2$ is obtained based on one or more of the following: an ultraviolet light transmittance $T_{UV}$ of the ultraviolet filter structure, conversion efficiency $\eta_{UV}$ of the ultraviolet light conversion layer, a visible light transmittance or an infrared light transmittance $T_{POL}$ of the polarizer, and optical-to-electrical conversion efficiency $E_1$ of the first light sensor.

4. The display module according to any one of claims 1 to 3, wherein the display module further comprises a light shielding layer, and the light shielding layer surrounds a periphery of the ultraviolet filter structure.

5. The display module according to any one of claims 1 to 4, wherein the ultraviolet filter structure further comprises ultraviolet filter ink and a nano-silver film that are disposed in a stacked manner.

6. The display module according to claim 5, wherein the nano-silver film is located on a side that is of the ultraviolet filter ink and that is close to the polarizer.

7. The display module according to any one of claims 1 to 6, wherein an orthographic projection of the ultraviolet filter structure on the polarizer is located in an orthographic projection of the ultraviolet light conversion layer on the polarizer.

8. The display module according to any one of claims 1 to 7, wherein the ultraviolet light conversion layer is configured to convert ultraviolet light of a first wavelength from the ultraviolet filter structure into visible light or infrared light of a second wavelength, and the first light sensor is specifically configured to detect the visible light or the infrared light of the second wavelength.

9. The display module according to claim 8, wherein the display module further comprises a third light sensor, the ultraviolet light conversion layer is configured to convert ultraviolet light of a third wavelength from the ultraviolet filter structure into visible light or infrared light of a fourth wavelength, the light emitted from the ultraviolet light conversion layer is configured to be emitted into the third light sensor through the polarizer, and the third light sensor is configured to detect the visible light or the infrared light of the fourth wavelength.

10. The display module according to any one of claims 1 to 9, wherein the display module further comprises a cover plate, and the ultraviolet filter structure is disposed on the cover plate.

11. The display module according to any one of claims 1 to 10, wherein the ultraviolet light conversion layer is attached to the ultraviolet filter structure.

12. The display module according to any one of claims 1 to 11, wherein the display module further comprises the display panel, the display panel comprises the front panel and the backplane, the first light sensor is packaged between the front panel and the backplane, and the first light sensor is electrically connected to a drive circuit on the backplane.

13. An electronic device, comprising the display module according to any one of claims 1 to 12.

100

FIG. 1

FIG. 2

20

363 361

310

362 320

330

343 30

340 341

342

Display area

Ultraviolet light
detection area

FIG. 3

100

30

Ultraviolet light detection area

20

Display area

351

353

354

352

FIG. 4

310

361

362

320

330

340

301

FIG. 5

FIG. 6

FIG. 7

FIG. 8

FIG. 9

FIG. 10

FIG. 11

Wavelength (nm)

200    280    315    400

| UVC | UVB | UVA | Visible light + infrared light |

Ultraviolet
filter ink

Nano-
silver film

FIG. 12

Transmittance (%)

3

2.5

2

1.5

1

0.5

0

200                400                600                800

Wavelength (nm)

FIG. 13

100

FIG. 14

FIG. 15

100

UV index
2.7
Recommended
protection measure

Sunscreen lotion with
a 30+ SPF
Sunshade hat
Sunscreen suit

FIG. 16

100

UV index

Sun protection guide

1. Sunscreen lotion with a 30+ SPF
2. Sunglasses
3. Sunshade hat + sunscreen suit
4. Find a sunshade place

Outdoor activity duration-UV index

6:00   8:00  10:00  12:00  14:00  16:00  18:00

Outdoor activity guide
1. Outdoor activity duration has reached 6
hours today
2. Please take a sun protection measure
according to the sun protection guide. Please
end the outdoor activity if a sun protection
measure is insufficient.

FIG. 17

## INTERNATIONAL SEARCH REPORT

| International application No. |
| --- |
| **PCT/CN2022/112471** |

**A.    CLASSIFICATION OF SUBJECT MATTER**

H01L 27/32(2006.01)i;  G01J 1/16(2006.01)i

According to International Patent Classification (IPC) or to both national classification and IPC

**B.    FIELDS SEARCHED**

Minimum documentation searched (classification system followed by classification symbols)

H01L27/-;  G01J1/-

Documentation searched other than minimum documentation to the extent that such documents are included in the fields searched

Electronic data base consulted during the international search (name of data base and, where practicable, search terms used)

CNABS; CNTXT; VEN; DWPI; WOTXT; EPTXT; USTXT; CNKI: 显示, 紫外, 偏光, 转换, 传感器, 探测, 滤光, 可见光, 红外光, display, ultraviolet, polarized light, switch, sensor, detect, filter, visible light, infrared light

**C.    DOCUMENTS CONSIDERED TO BE RELEVANT**

| Category* | Citation of document, with indication, where appropriate, of the relevant passages | Relevant to claim No. |
| --- | --- | --- |
| Y | CN 101788338 A (TOPPOLY OPTOELECTRONICS CORP.) 28 July 2010 (2010-07-28) description, paragraphs 22-42, and figures 1A-9D | 1-13 |
| Y | US 2020082693 A1 (ROHM CO., LTD.) 12 March 2020 (2020-03-12) description, paragraphs 30-58, and figures 1-8 | 1-13 |
| Y | WO 2016129962 A1 (KOREA MACHINERY & MATERIALS INSTITUTE) 18 August 2016 (2016-08-18) description, paragraphs 38-73, and figures 1-12 | 1-13 |
| Y | EP 3270125 A1 (AMS AG.) 17 January 2018 (2018-01-17) description, paragraphs 36-51, and figures 1-3 | 1-13 |
| A | CN 110319928 A (SHARP CORP.) 11 October 2019 (2019-10-11) entire document | 1-13 |
| A | CN 201110786 Y (SICHUAN WEST ZONE HIGH-TECH DEVELOPMENT CO., LTD.) 03 September 2008 (2008-09-03) entire document | 1-13 |
| A | CN 105405914 A (MAXIM INTEGRATED PRODUCTS, INC.) 16 March 2016 (2016-03-16) entire document | 1-13 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **13 October 2022** | **27 October 2022** |

| Name and mailing address of the ISA/CN | Authorized officer |
| --- | --- |
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/112471**

| Patent document cited in search report | | | Publication date (day/month/year) | Patent family member(s) | | | Publication date (day/month/year) |
|---|---|---|---|---|---|---|---|
| CN | 101788338 | A | 28 July 2010 | US | 2010187426 | A1 | 29 July 2010 |
| | | | | TW | 201028671 | A | 01 August 2010 |
| | | | | CN | 101788338 | B | 09 July 2014 |
| | | | | TW | I420085 | B | 21 December 2013 |
| | | | | US | 8581212 | B2 | 12 November 2013 |
| US | 2020082693 | A1 | 12 March 2020 | JP | 2020041922 | A | 19 March 2020 |
| | | | | US | 11011039 | B2 | 18 May 2021 |
| WO | 2016129962 | A1 | 18 August 2016 | KR | 20160099995 | A | 23 August 2016 |
| | | | | KR | 101892694 | B1 | 28 August 2018 |
| EP | 3270125 | A1 | 17 January 2018 | None | | | |
| CN | 110319928 | A | 11 October 2019 | US | 2019301928 | A1 | 03 October 2019 |
| CN | 201110786 | Y | 03 September 2008 | None | | | |
| CN | 105405914 | A | 16 March 2016 | US | 2015338273 | A1 | 26 November 2015 |
| | | | | US | 10132679 | B2 | 20 November 2018 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110992375